# EUROPEAN PATENT APPLICATION

(11) **EP 2 051 311 A1**
(43) Date of publication of application: **22.04.2009**
(21) Application number: 07118528.4
(22) Date of filing: 15.10.2007
(51) Int. Cl.: H01L 51/52

(54) **Method of providing an encapsulation layer stack, coating device and coating system**

(71) Applicant: Applied Materials, Inc., Santa Clara, CA 95054 (US)
(72) Inventor: Hoffmann, Uwe, 63755 Alzenau (DE); Dieguez-Campo, José Manuel, 63457 Hanau (DE)
(74) Representative: Lang, Christian

(57) **Abstract**

A coating system or encapsulation module 1 is coupled with a substrate handling module 2, wherein substrates 3a to be encapsulated and substrates 3b that already have an encapsulation layer stack deposited thereon are handled in a nitrogen atmosphere. The substrate handling module 2 comprises a magazine 4 for storing substrates 3a to be coated and encapsulated substrates 3b. A handling device 5 unloads the substrates 3a to be coated from the magazine 4 and loads encapsulated substrates 3b into the magazine 4. The encapsulation module 1 has a first ink-jet coating chamber 10a. In said first ink-jet coating chamber 10a a photoresist layer is deposited on the substrate 3a by means of an ink-jet printing method. The ink-jet printing method is carried out in an atmosphere of about 10 mbar. Then the substrate 3a is transported into a first CVD (chemical vapor deposition) coating chamber 11a. In the CVD coating chamber 11a a first silicon nitride layer is deposited on the substrate 3a, i.e. on the photoresist layer, by using a CVD coating method at a pressure of about 10⁻² mbar to 10⁻³ mbar. This process is repeated in second and third ink-jet coating chambers 10b, 10c and second and third CVD coating chambers 11b, 11c, respectively.

## Description

### TECHNICAL FIELD

The present invention relates to a method of providing an encapsulation layer stack on substrate, comprising the steps of:
a) depositing a first layer on that substrate using a vacuum deposition process; and
b) depositing a second layer on that substrate using a fluid coating material.

### PRIOR ART

In a number of technical applications, thin layer stacks and thin layer systems are becoming more and more important, e.g. in the production of displays, such as LED-displays, LCD-displays, OLED-displays, etc.

However, a number of thin layers or layer systems, particularly OLED layer systems, are quite sensitive with respect to environmental influences such as oxygen or water vapour. Therefore, these thin layer systems are provided with protective barriers (encapsulation layers or encapsulation layer stacks) which prevent vapour and oxygen from permeating the layer system.

Generally, the single layers of the protective barrier stack may be deposited by using conventional vacuum coating processes such as evaporation, CVD (chemical vapour deposition), PECVD (plasma enhanced chemical vapour deposition), sputtering methods, etc. Some materials, e.g. polymer compounds, are particularly deposited by using liquid coating methods, such as spin coating or printing methods.

An example of a protective layer is disclosed e.g. in document US 6,522,067 B1. According to this document, the polymer layers in a barrier stack is deposited in vacuum or by using atmospheric processes such as spin coating and/ or spraying.

The first barrier layer or barrier stack may comprise materials selected from metal oxides, metal nitrides, metal carbides, metal oxynitrides and combinations thereof. A second layer may be for example a polymer layer. Usually the first barrier layer is deposited in vacuum atmosphere, whereas the second layer is deposited by using atmospheric processes such as spin coating, spraying, etc.

However, when depositing a first layer by using a vacuum deposition process and a second layer by using a liquid coating process, these processes are not compatible, i.e. the process parameters, e.g. the pressure in the coating environment, are significantly different. Particularly, when depositing a plurality of thin first and second layers alternately, the process requires multiple transport steps between different coating stations and different pressure zones. Of course, this makes it difficult to design an in-line coating system having a high throughput.

Document WO03/098716 discloses a method for manufacturing an encapsulated polymer OLED. The encapsulation layers comprise a photoresist layer which is deposited by using conventional methods such as printing methods or mechanical coating techniques after the substrate has been removed from a vacuum chamber.

### OBJECT OF INVENTION

It is an object of the present invention to provide a method of providing an encapsulation layer stack on a substrate and a coating device allowing the deposition of an encapsulation layer stack with an increased throughput.

### TECHNICAL SOLUTION

This object is achieved by a method of depositing an encapsulation layer stack on a substrate according to claim 1, a coating device according to claim 8, and a coating system according to claim 12.

The method of providing an encapsulation layer stack on a substrate comprises the steps of:
a) depositing a first layer on a substrate using a vacuum deposition process; and
b) depositing a second layer on that substrate using a fluid/ liquid coating material, wherein
step b) is carried out in a reduced pressure atmosphere.

The encapsulation layer stack is deposited on a substrate. The substrate may already comprise coating layers, e.g. functional layers. Particularly, the substrate may be coated with an OLED layer system or an OLED layer before depositing the encapsulation layer stack. The encapsulation layer stack may be deposited on the substrate in order to protect an OLED layer system from humidity and/or oxygen. The layer stack comprises two or more layers, one of the two layers being deposited in a vacuum deposition process such as sputtering, chemical vapour deposition (CVD), plasma enhanced chemical vapour deposition (PECVD), evaporation, sublimation, etc., and one of them being deposited using a fluid coating process. Fluid coating processes are all processes wherein a fluid coating material, particularly a liquid coating material, is directly deposited on the substrate.

The first barrier layer or barrier stack may comprise materials selected from metal oxides, metal nitrides, metal carbides, metal oxynitrides and combinations thereof. The second layer may comprise for example a polymer material or a photoresist. The photoresist may be deposited in a low pressure or vacuum atmosphere using an ink-jet printing method. Then, e.g. a silicon nitride layer may be deposited in a vacuum atmosphere.

According to the present invention, a fluid/ liquid deposition method is used for depositing the second layer, particularly, printing, especially ink-jet printing. The second layer is deposited directly on the first layer or indirectly, i.e. after one or more intermediate layers have been deposited on the first layer. Furthermore, the order of carrying out process steps a) and b) is not determined.

The invention is characterized by the fact that the deposition of the second layer is carried out in a reduced pressure atmosphere. Therefore, the atmosphere during deposition step a) and the atmosphere during the deposition step b) are both low pressure atmospheres and/or vacuum pressure atmospheres. Furthermore, the pressure difference between the first pressure generated for carrying out process step a) and the second pressure generated for carrying out process step b) is quite small. Consequently, venting and evacuation of the process chamber(s) may be reduced during the deposition of the encapsulation layer stack thus reducing the handling time between the deposition steps. Consequently, the throughput of the encapsulation station may be increased. Furthermore, contamination may be reduced.

In a preferred embodiment, the said fluid/ liquid coating material may be deposited in said deposition step b) by means of a fluid/ liquid coating method, particularly by a printing method, especially by an ink-jet-printing method.

In the method according to the present invention, the reduced pressure during deposition step b) may be less than 100 mbar, particularly less than 50 mbar, particularly less than 20 mbar, particularly less than 10 mbar. For example, when a silicon nitride layer is deposited in process step a) using a CVD process a pressure between 10⁻² and 10⁻³ mbar is required. In a conventional method, a photoresist (which may be solvent free and/or an UV photoresist) is deposited afterwards at an atmospheric pressure. However, according to the present invention, the second layer, i.e. the photoresist layer, is deposited in a reduced pressure atmosphere of, e.g. about 20 mbar or 10 mbar or a few 10 mbar.

In a preferred embodiment the pressure during said vacuum deposition step a) is less than 1 mbar, particularly less than 10⁻¹ mbar, particularly less than to 10⁻² mbar, particularly less than 10⁻³ mbar.

The pressure difference between said reduced pressure atmosphere and a pressure in a fluid/liquid coating material reservoir may be set to be between 2,5 mbar and 50 mbar, particularly between 5 and 15 mbar during said deposition step b).

Said first layer and said second layer may be deposited on said substrate in a first coating chamber subsequently. Of course, in this case, the coating chamber requires coating tools for a vacuum deposition process carried out in step a), and coating tools for the fluid/ liquid coating process carried out in step b).

In another embodiment of the invention said first layer is deposited in a first coating chamber and said second layer is deposited in a second coating chamber. The first and second coating chambers may be directly or indirectly connected with each other. An in-line coating system may be designed for producing layer stacks (and/or functional layers) on a substrate, wherein the in-line system has a high throughput due to relatively small pressure differences between the process steps a) and b).

The second layer may be deposited in the same coating chamber or the substrate may be transported into a connected ink-jet coating chamber and processed therein. After the deposition and after hardening the photoresist, the substrate may be transported into another coating chamber. The other coating chamber may be evacuated to a CVD-working pressure between 10⁻² and 10⁻³ mbar. The sequence may be repeated until a complete stack of encapsulation layers has been produced on the substrate. Thus, a vacuum coating process may be coupled with a process which is usually carried out under atmospheric pressure. By means of the present invention, coating processes may be combined easily. Furthermore, a reduction of spurious particles in the coating chamber(s) may be achieved.

The object of the invention is also achieved by providing a coating device, particularly for carrying out a method as described above. The coating device according to the present invention comprises at least a process chamber, particularly a vacuum process chamber, and at least a fluid and/or liquid coating tool arranged within the process chamber for depositing a layer on a substrate, wherein the liquid coating tool comprises and ink-jet printing device. The ink-jet printing device is characterized by the fact that the ink-jet printing device comprises means for controlling and/or setting the pressure of the fluid and/ or liquid coating material comprised in said coating material reservoir of said ink-jet printing device. Said means are particularly designed to reduce the pressure in the fluid and/ or liquid coating material.

When combining and/or coupling vacuum treatment processes and ink-jet printing processes, in conventional coating devices the atmosphere in a respective vacuum coating chamber has to be a vacuum atmosphere for the vacuum treatment step and a normal pressure atmosphere for the ink-jet printing step, respectively. Accordingly, the conventional system has to be vented/ evaporated many times (over large ranges) before the production of the encapsulation barrier stack may be finished. Accordingly, the cycle times are quite long and the through-put is limited. Moreover, venting and evacuating involving large pressure differences causes spurious particles to enter the coating chambers. These particles may contaminate or damage the encapsulation barrier system.

Ink-jet printing may be carried out by using print heads operated on the basis of piezoelectric and/or thermal effects. Such print heads may be operated in a reduced pressure atmosphere when selecting a set of suitable process parameters. Usually, a pressure difference between 10 mbar and 20 mbar must be provided between a fluid/ liquid coating material reservoir and an orifice outlet of the print head which is provided for depositing the fluid/ liquid coating material on the substrate.

Particularly, the coating device comprises a control unit for controlling the pressure in the fluid/ liquid coating material, comprised in the reservoir of the ink-jet device to exceed the pressure within the vacuum process chamber. The pressure difference is a predetermined pressure difference.

The process chamber may further comprise at least a vacuum process coating tool, particularly a CVD coating tool.

A coating system according to the present invention comprises an arrangement of at least a first coating device as described above, and a treatment device comprising at least a treatment chamber and vacuum treatment tools.

Particularly, the treatment chamber comprises at least a second coating chamber, and said vacuum treatment tools comprise at least second vacuum coating tools for depositing a layer on a substrate by means of a vacuum coating process. In an alternative embodiment, the treatment device may be an etching device, cleaning device, etc.

The second vacuum coating tools may comprise sputter tools, CVD coating tools, PECVD coating tools, and/ or evaporation tools.

In a preferred embodiment, the arrangement of the process chamber and the treatment chamber is an in-line arrangement, i. e. the coating system may comprise an in-line arrangement of a first coating device and a second coating device.

Particularly, the coating system may comprise an in-line arrangement and/ or an alternate arrangement of a plurality of first coating chambers and treatment chambers. Thus an encapsulation layer stack may be deposited on a substrate within a short cycle time.

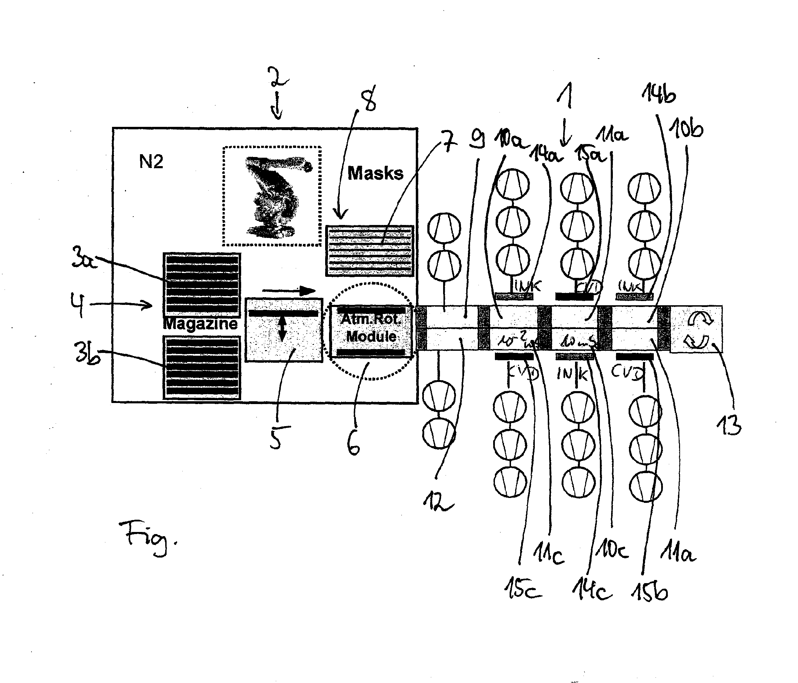

### BRIEF DESCRIPTION OF THE DRAWING

Further objects and advantages result from the following description of a specific embodiment. The figure illustrates a coating system according to the present invention.

### DESCRIPTION OF A SPECIFIC EMBODIMENT

The figure shows a coating system or encapsulation module 1 according to the present invention.

The encapsulation module 1 is coupled with a substrate handling module 2, wherein substrates 3a to be encapsulated and substrates 3b that already have an encapsulation layer stack deposited thereon are handled in a nitrogen atmosphere.

The substrate handling module 2 comprises a magazine 4 for storing substrates 3a to be coated and encapsulated substrates 3b. A handling device 5 unloads the substrates 3a to be coated from the magazine 4 and loads encapsulated substrates 3b into the magazine 4.

Furthermore, the substrate handling module 2 comprises a rotatable transfer module 6 which works in a normal pressure atmosphere. A substrate 3a to be coated is transferred from the magazine 4 into the rotatable transfer module 6 by means of the handling device 5. In the rotatable transfer module 6 substrates 3a, 3b and masks 7 are handled and arranged relative to each other. The respective masks 7 are kept in a mask storage 8 which is also arranged within the substrate handling module 2.

After a substrate 3a and a mask 7 have been aligned in the rotatable transfer module 6 the substrate 3a and the mask 7 are transferred to a transfer chamber 9 (lock-in chamber 9) of the encapsulation module 1. Then the pressure in the lock-in chamber 9 is reduced to a low pressure of about 20 mbar and transferred into a first ink-jet coating chamber 10a.

In the first ink-jet coating chamber 10a a photoresist layer is deposited on the substrate 3a by means of an ink-jet printing method. The ink-jet printing method is carried out in an atmosphere of about 20 mbar. When the photoresist layer has hardened the pressure in the first ink-jet coating chamber 10a is reduced to a vacuum pressure between 10⁻² mbar and 10⁻³ mbar. Then the substrate 3a is transported into a first CVD (chemical vapor deposition) coating chamber 11a. In the CVD coating chamber 11a a first silicon nitride layer is deposited on the substrate 3a, i.e. on the photoresist layer, by using a CVD coating method at a pressure of about 10⁻² mbar to 10⁻³ mbar.

After the silicon nitride layer has been deposited the pressure in the first CVD coating chamber 11 a is increased to a pressure of about 20 mbar. Then, the substrate 4 is transported into a second ink-jet coating chamber 10b for receiving a second photoresist layer by means of an ink-jet method.

This sequence is repeated by providing a second silicon nitride layer in a second CVD coating chamber 11 b, a third photoresist layer in a third ink-jet coating chamber 10c, and a third silicon nitride layer in a third CVD coating chamber 11c. At this stage, the encapsulation layer consisting of three photoresist layers and three silicon nitride layers is finished. The encapsulated substrate 3b is transported back to the substrate handling module 2 via a transfer or lock-out chamber 12.

The encapsulation module 1 is an in-line arrangement of ink-jet coating chambers 10a, 10b, 10c and CVD coating chambers 11a, 11b, 11c. The ink-jet coating chambers 10a, 10b, 10c and the CVD coating chambers 11a, 11b, 11c are arranged alternately. Between the second ink-jet coating chamber 10b and the second CVD coating chamber 11b there is a rotatable transfer chamber 13 wherein the substrate is rotated by 180 ° in order to be aligned for the transport into the second CVD coating chamber 10b.

Between the substrate handling module 2, the encapsulation module 1, the transfer chambers 9, 12 and 13 and the coating chambers 10a, 10b, 10c, 11a, 11b, 11c there may be gate valves arranged for compensating the pressure difference between the chambers during the handling and coating process.

The ink-jet coating chambers 10a, 10b and 10c comprise ink-jet coating tools 14a, 14b, 14c, namely ink-jet print heads operated by means of piezoelectric or thermal effects. Furthermore, the ink-jet coating tools 14a, 14b, 14c each comprise at least a coating material reservoir for receiving the coating material and a pressure control unit for controlling the pressure in the coating material reservoir and/or the pressure difference between the coating material reservoir and the ink-jet coating chambers 10a, 10b, 10c .During a printing process the pressure within the coating material reservoir has to be about 10 mbar lower than the pressure in the respective ink-jet coating chamber 10a, 10b, 10c. This means that when the pressure in the ink-jet coating chamber 10a, 10b, 10c is about 10 mbar during the coating process, the pressure in the reservoir is controlled to be about 20 mbar.

Correspondingly, the CVD coating chambers 11a, 11b and 11c comprise CVD coating tools 15a, 15b and 15c, respectively. The CVD coating processes are typically carried out at a pressure between 10⁻² mbar to 10⁻³ mbar.

The process of depositing a photoresist layer and a silicon nitride layer is repeated in second and third ink-jet coating chambers 10b, 10c and second and third CVD coating chambers 11b, 11c, respectively.

Of course, the encapsulation module 1 comprises a pump system 16 in order to control and generate the pressure in the respective chambers 9, 10a, 10b, 10c, 11 a, 11 b, 11c, 12 and 13 during the encapsulation process.

By providing an in-line encapsulation module a high throughput and low contamination with spurious particles entering the system during venting steps may be obtained.

## Claims

1. A method of providing an encapsulation layer stack on a substrate (3a) comprises the steps of:
a) depositing a first layer on a substrate (3a) using a vacuum deposition process; and
b) depositing a second layer on said substrate (3a) using a fluid/ liquid coating material;
**characterized in that**
step b) is carried out in a reduced pressure atmosphere.

2. The method of claim 1,
**characterized in that**
said fluid/ liquid coating material is deposited in said deposition step b) by means of a fluid/ liquid coating method, particularly by a printing or spraying method, especially by an ink-jet-printing or spraying method.

3. The method of claim 1 or 2,
**characterized in that**
said reduced pressure atmosphere during said deposition step b) is less than or equal to 100 mbar, particularly less than or equal to 50 mbar, particularly less than or equal to 20 mbar, particularly less than or equal to 10 mbar.

4. The method according to any of the previous claims 1 to 3,
**characterized in that**
the pressure during said vacuum deposition step a) is less than 1 mbar, particularly less than 10⁻¹ mbar, particularly less than 10⁻² mbar, particularly less than 10⁻³ mbar.

5. The method according to any of the previous claims 1 to 4,
**characterized in that**
the pressure difference between said reduced pressure atmosphere and a pressure in a
fluid/ liquid coating material reservoir is set to be between 2,5 mbar and 50 mbar, particularly between 5 and 15 mbar during said deposition step b).

6. The method according to any of the previous claims 1 to 5,
**characterized in that**
said first layer and said second layer are deposited on said substrate (3a) in a first coating chamber subsequently.

7. The method according to any of the previous claims 1 to 5,
**characterized in that**
said first layer is deposited in a first coating chamber (10a, 10b, 10c) and said second layer is deposited in a second coating chamber (11 a, 11b, 11c).

8. A coating device, particularly for carrying out a method according to any of the previous claims 1 to 7, comprising:
at least one process chamber (10a, 10b, 10c); and
at least one fluid and/or liquid coating tool (14a, 14b, 14c) arranged within said process chamber (10a, 10b, 10c) for depositing a layer on a substrate (3a), wherein said liquid coating tool (14a, 14b, 14c) comprises an ink-jet printing device having at least a coating material reservoir for receiving fluid and/ or liquid coating material;
**characterized in that**
said coating device (1) comprises means for controlling and/or setting the pressure of the fluid and/ or liquid coating material comprised in said coating material reservoir of said ink-jet printing device.

9. The coating device of claim 8,
**characterized in that**
said ink-jet printing device comprises at least a print head, particularly a print head operated on the basis of piezoelectric and/or thermal effects.

10. The coating device of claim 8 or 9,
**characterized in that**
said coating device (1) comprises a control unit for controlling the pressure in the fluid/liquid coating material comprised in the coating material reservoir of the ink-jet printing device to exceed the pressure within the process chamber.

11. The coating device according to any of the previous claims 8 to 10,
**characterized in that**
said process chamber (10a, 10b, 10c) further comprises at least a vacuum process coating tool (15a, 15b, 15c), particularly a CVD coating tool.

12. A coating system (1) comprising an arrangement of at least a first coating device according to any of the previous claims 8 to 11, and a treatment device comprising at least a treatment chamber (11 a, 11b, 11c) and vacuum treatment tools (15a, 15b, 15c).

13. The coating system (1) according to claim 12,
**characterized in that**
said treatment chamber (11a, 11b, 11c) comprises at least a second coating chamber, and said vacuum treatment tools (15a, 15b, 15c) comprise at least second vacuum coating tools for depositing a layer on a substrate (3a) by means of a vacuum coating process.

14. The coating system (1) according to claim 13,
**characterized in that**
said second vacuum coating tools comprise sputter tools, CVD coating tools, PECVD coating tools, and/ or evaporation tools.

15. The coating system (1) according to any of the previous claims 12 to 14,
**characterized in that**
said arrangement of said process chamber (10a, 10b, 10c) and said treatment chamber (11 a, 11b, 11c) is an in-line arrangement.

16. The coating system (1) according to any of the previous claims 12 to 15,
**characterized in that**
said coating system (1) comprises an in-line arrangement of a plurality of first coating chambers and treatment chambers, particularly arranged alternately.

## Amended claims

### Amended claims in accordance with Rule 137(2) EPC.

**1.** A method of providing an encapsulation layer stack on a substrate (3a) comprises the steps of:
a) depositing a first layer on a substrate (3a) using a vacuum deposition process; and
b) depositing a second layer on said substrate (3a) using a liquid coating material in a liquid coating method;
**characterized in that**
step b) is carried out in a reduced pressure atmosphere.

**2.** The method of claim 1,
**characterized in that**
said liquid coating material is deposited in said deposition step b) by means of a printing or spraying method, especially by an ink-jet-printing or spraying method.

**3.** The method of claim 1 or 2,
**characterized in that**
said reduced pressure atmosphere during said deposition step b) is less than or equal to 100 mbar, particularly less than or equal to 50 mbar, particularly less than or equal to 20 mbar, particularly less than or equal to 10 mbar.

**4.** The method according to any of the previous claims 1 to 3,
**characterized in that**
the pressure during said vacuum deposition step a) is less than 1 mbar, particularly less than 10⁻¹ mbar, particularly less than 10⁻² mbar, particularly less than 10⁻³ mbar.

**5.** The method according to any of the previous claims 1 to 4,
**characterized in that**
the pressure difference between said reduced pressure atmosphere and a pressure in a liquid coating material reservoir is set to be between 2,5 mbar and 50 mbar, particularly between 5 and 15 mbar during said deposition step b).

**6.** The method according to any of the previous claims 1 to 5,
**characterized in that**
said first layer and said second layer are deposited on said substrate (3a) in a first coating chamber subsequently.

**7.** The method according to any of the previous claims 1 to 5,
**characterized in that**
said first layer is deposited in a first coating chamber (10a, 10b, 10c) and said second layer is deposited in a second coating chamber (11a, 11b,11c).

**8.** A coating device, for carrying out a method according to any of the previous claims 1 to 7 comprising:
at least one process chamber (10a, 10b, 10c); and
at least one liquid coating tool (14a, 14b, 14c) arranged within said process chamber (10a, 10b, 10c) for depositing a layer on a substrate (3a), wherein said liquid coating tool (14a, 14b, 14c) comprises an ink-jet printing device having at least a coating
material reservoir for receiving liquid coating material;
**characterized in that**
said coating device (1) comprises means for controlling and/or setting the pressure of the liquid coating material comprised in said coating material reservoir of said ink-jet printing device to a reduced pressure compared with atmospheric pressure.

**9.** The coating device of claim 8,
**characterized in that**
said ink-jet printing device comprises at least a print head, particularly a print head operated on the basis of piezoelectric and/or thermal effects.

**10.** The coating device of claim 8 or 9,
**characterized in that**
said coating device (1) comprises a control unit for controlling the pressure in the fluid liquid coating material comprised in the coating material reservoir of the ink-jet printing device to exceed the pressure within the process chamber.

**11.** The coating device according to any of the previous claims 8 to 10,
**characterized in that**
said process chamber (10a, 10b, 10c) further comprises at least a vacuum process coating tool (15a, 15b, 15c), particularly a CVD coating tool.

**12.** A coating system (1) comprising an arrangement of at least a first coating device according to any of the previous claims 8 to 11, and a treatment device comprising at least a treatment chamber (11a, 11b, 11c) and vacuum treatment tools (15a, 15b, 15c).

**13.** The coating system (1) according to claim 12,
**characterized in that**
said treatment chamber (11a, 11b, 11c) comprises at least a second coating chamber, and said vacuum treatment tools (15a, 15b, 15c) comprise at least second vacuum coating tools for depositing a layer on a substrate (3a) by means of a vacuum coating process.

**14.** The coating system (1) according to claim 13,
**characterized in that**
said second vacuum coating tools comprise sputter tools, CVD coating tools, PECVD coating tools, and/ or evaporation tools.

**15.** The coating system (1) according to any of the previous claims 12 to 14,
**characterized in that**
said arrangement of said process chamber (10a, 10b, 10c) and said treatment chamber (11a, 11b, 11c) is an in-line arrangement.

**16.** The coating system (1) according to any of the previous claims 12 to 15,
**characterized in that**
said coating system (1) comprises an in-line arrangement of a plurality of first coating chambers and treatment chambers, particularly arranged alternately.
